Europäisches Patentamt

European Patent Office

Office européen des brevets

(19)

(11) Veröffentlichungsnummer: **0 282 632 B1**

# EUROPÄISCHE PATENTSCHRIFT

(12)

(45) Veröffentlichungstag der Patentschrift: **05.08.92**

(51) Int. Cl.⁵: **G01R 11/58**, C22F 1/00

(21) Anmeldenummer: **87113895.4**

(22) Anmeldetag: **23.09.87**

(54) Zweifachzähleinrichtung mit zwei Rollenzählwerken.

(30) Priorität: **19.01.87 CH 170/87**

(43) Veröffentlichungstag der Anmeldung:
**21.09.88 Patentblatt 88/38**

(45) Bekanntmachung des Hinweises auf die
Patenterteilung:
**05.08.92 Patentblatt 92/32**

(84) Benannte Vertragsstaaten:
**CH DE ES FR GR IT LI NL**

(56) Entgegenhaltungen:
**CH-A- 140 151**
**DE-B- 2 150 412**
**US-A- 3 652 969**

**METALL, Band 39, Nr. 1, 1985, Seiten 34-38,**
**Metall-Verlag, Berlin, DE; P. TAUTZENBER-**
**GER et al.: "Anwendung von Memory-**
**Legierungen in elektrischen Schaltgeräten"**

(73) Patentinhaber: **Landis & Gyr Betriebs AG**

**CH-6301 Zug(CH)**

(72) Erfinder: **Rimpler, Heinz**
**Scheidegghalde 1**
**CH-6038 Gisikon(CH)**
Erfinder: **Behringer, Alfred**
**Eschenweg 8**
**CH-6340 Baar(CH)**
Erfinder: **Partel, Robert**
**Leihgasse 24**
**CH-6340 Baar(CH)**

(74) Vertreter: **Müller, Hans-Jürgen, Dipl.-Ing. et al**
**Müller, Schupfner & Gauger Maximilianstras-**
**se 6 Postfach 10 11 61**
**W-8000 München 1(DE)**

**Beschreibung**

Die Erfindung betrifft eine Zweifachzähleinrichtung mit zwei Rollenzählwerken nach dem oberbegriff des Patentanspruchs 1.

Zweifachzähleinrichtungen werden beispielsweise für die Zählung des Energie-, Wasser- oder Gasverbrauchs, aber auch für die Zählung anderer Grössen benutzt, wenn von der Grösse zwei getrennte Ergebnisse erhalten werden sollen, die in einander abwechselnden Zeiten anfallen. Als Beispiel sei die Zählung der verbrauchten Elektrizitätsmenge bei Berechnung nach Tag- und Nachttarif genannt. Die beiden Ergebnisse können auf zwei Rollenzählwerken dargestellt werden, die wechselweise an einen als Geber dienenden Zähler, der während beider Zählzeiten läuft, angeschlossen werden.

Es ist eine grosse Zahl von Zweifachzähleinrichtungen mit zwei Rollenzählwerken bekannt geworden, die alle elektromagnetisch arbeiten. Sie weisen eine Antriebseinrichtung auf, ferner eine Umschalteinrichtung zwischen den Rollenzählwerken, bei der je nach dem Zustand einer Steuergrösse der Strom in einer Magnetspule an- oder abgeschaltet und dadurch ein Anker angezogen wird oder abfällt, wodurch über geeignete mechanische Uebertragungen die Antriebseinrichtung entweder auf das eine oder auf das andere Rollenzählwerk wirkt. Solche Zählwerke sind beispielsweise in der DE-PS 21 50 412 und der DE-OS 24 61 939 beschrieben und unterscheiden sich in der Art der mechanischen Uebertragung. Derartige Zweifachzähleinrichtungen schalten jedoch verhältnismässig hart um, was ihre Lebensdauer beschränken kann. Ausserdem ist der Energieverbrauch über die Zeit, in der dasjenige Rollenzählwerk läuft, das angetrieben wird, wenn in der Magnetspule Strom fliesst, verhältnismässig gross. Weiter benötigen sie zu ihrem Aufbau vergleichsweise teure Bauteile wie die Magnetspule und den Anker.

Im weiteren ist eine Zweifachzähleinrichtung der im Oberbegriff des Anspruchs 1 genannten Art bekannt (CH-PS 140 151), bei dem die Umschaltung durch eine von einem Steuerstrom überwachte Bimetallanordnung auf mechanischem Wege bewerkstelligt wird.

Es ist auch bekannt (METALL, Band 39, Januar 1985, Seiten 34 - 38; P. Tautzenberger, D. Stöckel: Anwendung von Memory-Legierungen in elektrischen Schaltgeräten), Legierungen mit thermischem Gedächtniseffekt in Thermoschaltern zu verwenden.

Der Erfindung liegt die Aufgabe zugrunde, eine Zweifachzähleinrichtung zu schaffen, die die Umschaltung von dem einen zum anderen Rollenzählwerk weicher durchführt, d. h. den Umschaltvorgang über eine Zeit von mindestens einigen zehntel Sekunden ausdehnt, aber auch einen geringen Energieverbrauch aufweist und mit preiswerteren Bauteilen auskommt als andere Zweifachzähleinrichtungen nach dem Stand der Technik.

Diese Aufgabe wird durch die Merkmale des Kennzeichenteils des Anspuchs 1 gelöst. Die weiteren Ansprüche beziehen sich auf vorteilhafte Ausführungsformen einer Zähleinrichtung nach der Erfindung.

Ausführungsbeispiele der Erfindung werden in folgendem an Hand der Zeichnung näher erläutert. Es zeigen:

Fig. 1    die Temperaturabhängigkeit der Länge eines Stabes aus einer Legierung mit thermischem Gedächtniseffekt;

Fig. 2    die Abhängigkeit der Umwandlungstemperatur Ts von der Zusammensetzung einer Legierung mit thermischem Gedächtniseffekt;

Fig. 3    eine Zweifachzähleinrichtung, die mit einer Umschalteinrichtung mit thermischem Gedächtniseffekt arbeitet, das obere Rollenzählwerk angetrieben;

Fig. 4    dieselbe Einrichtung, das untere Rollenzählwerk angetrieben, und

Fig. 5    eine andere Umschalteinrichtung.

Gleiche oder gleichartige Teile sind in den Figuren mit den gleichen Bezugszeichen versehen.

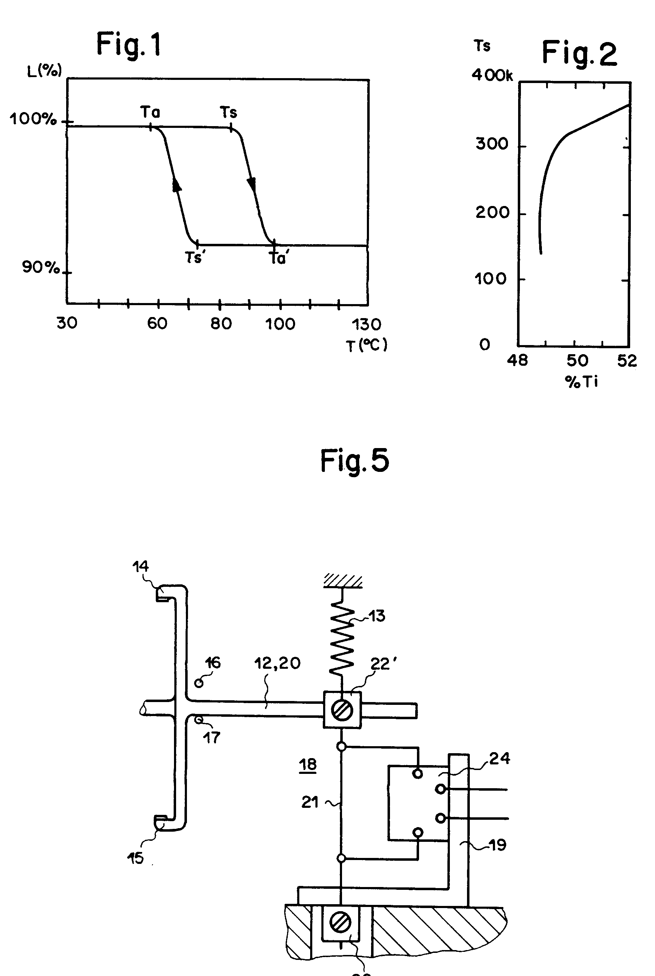

In den vergangenen Jahren wurden Legierungen mit thermischem Gedächtniseffekt entwickelt. Die Fig. 1 zeigt die Abhängigkeit der Länge 1 eines Stabes aus einer solchen Legierung von der Temperatur T. Bei Erwärmen über die Umwandlungstemperatur Ts hinaus zieht sich der Stab zusammen und erreicht bei der oberen Veränderungstemperatur Ta' eine kleinere Ausgangslänge für höhere Temperaturen. Diese kann beispielsweise bis 8 % unter der Länge bei Ts liegen. Kühlt man ihn danach ab, so dehnt er sich beim Unterschreiten der Temperatur Ts' wieder aus und erlangt bei der unteren Veränderungstemperatur Ta seine um die normale thermische Ausdehnung im Niedertemperaturgebiet korrigierte ursprüngliche Länge. Im Gebiet zwischen den Endtemperaturen Ta und Ta' zeigt der Stab somit ein typisches Hystereseverhalten. Diese Längenänderung infolge des thermischen Gedächtniseffektes erfolgt in umgekehrter Richtung wie die übliche thermische Ausdehnung von Metallen und Legierungen, hat einen sehr viel grösseren Temperaturkoeffizienten und erfolgt auch entgegen einer Kraft. Der thermische Gedächtniseffekt ist am grössten bei Legierungen, die zu 53,5 bis 56,5 % aus Nickel, der Rest aus Titan, bestehen.

Die Fig. 2 zeigt die Abhängigkeit der Umwandlungstemperatur Ts von der Zusammensetzung einer Nickel-Titan Legierung. Danach ändert sich die Umwandlungstemperatur Ts stark bei kleinen Konzentrationsänderungen. Man erkennt, dass die Legierungszusammensetzung sehr genau eingehalten werden muss, um ein reproduzierbares Verhalten der Teile in der Serienfertigung, wie zur Herstellung von Zweifachzähleinrichtungen, zu gewährleisten.

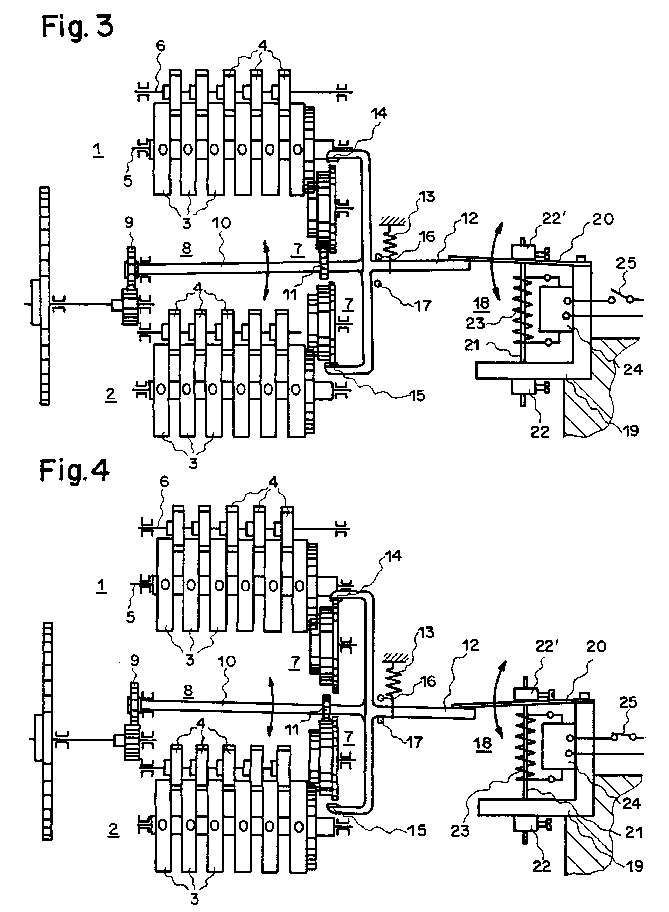

Zum Aufbau der hier beschriebenen Zweifachzähleinrichtungen werden Teile mit thermischem Gedächtniseffekt verwendet. Eine solche Einrichtung ist in den Fig. 3 und 4 beispielhaft dargestellt. Sie besteht aus zwei Rollenzählwerken 1 und 2, aus einer Antriebseinrichtung 8 und einer Umschalteinrichtung 18.

Die beiden Rollenzählwerke 1 und 2 besitzen jeweils Zahlenrollen 3 und Schaltrollen 4, die auf einer Zahlenrollenachse 5 beziehungsweise auf einer Schaltrollenachse 6 angeordnet sind, ferner jeweils ein Rollenzählwerksgetriebe 7.

Die Antriebseinrichtung 8 besteht im dargestellten Falle aus einem Zahnrad 9, einer Antriebsachse 10, einem Antriebszahnrad 11 und einem Hebel 12, der fest mit der Antriebsachse 10 verbunden ist. Die Antriebseinrichtung 8 ist in der Zeichenebene um einen kleinen Winkel um den Mittelpunkt des Zahnrads 9 schwenkbar. Der Hebel 12 ist an einer Feder 13 befestigt und besitzt in der Zeichenebene zwei Fortsätze, die in einem oberen Eingriff 14 und einem unteren Eingriff 15 enden. Die Winkelbewegung der Antriebseinrichtung 8 ist durch einen oberen Anschlag 16 und einen unteren Anschlag 17, die am Hebel 12 angreifen, begrenzt. Es können auch andere Antriebseinrichtungen 8 in den beschriebenen Zweifachzähleinrichtungen benutzt werden.

Die Umschalteinrichtung 18 ist auf einem festen Teil aufgebaut, hier einem Winkel 19, der fest mit dem Gehäuse der Einrichtung verbunden ist. Im Beispiel trägt der Winkel 19 am Ende eines seiner Arme, parallel zu dem anderen Arm, als beweglicher Teil eine Blattfeder 20. Zwischen dem Winkel 19 und der Blattfeder 20, also zwischen dem festen Teil und dem beweglichen Teil, ist ein Körper mit thermischem Gedächtniseffekt, hier ein Draht 21, an zwei Klemmen 22, 22′ eingespannt. Dieser Körper, also hier der Draht 21, nimmt unterhalb einer unteren Veränderungstemperatur Ta eine grosse und über einer oberen Veränderungstemperatur Ta′ eine kleine Ausdehnung, also Länge, ein. Die Blattfeder 20 spannt den Draht 21 ständig und wandelt Längenänderungen des Drahtes 21 durch Druck auf den Hebel 12, der durch die Feder 13 entgegen der Richtung dieses Druckes gezogen wird, um in kleine Aenderungen des Winkels, um den die Antriebseinrichtung 8 um das Zahnrad 9 geschwenkt wird, also in eine Lagenänderung der Antriebseinrichtung 8. Es ist eine ausschaltbare Heizung 23 vorhanden, um den Körper zeitweise über die obere Umwandlungstemperatur Ta′ aufzuheizen. Dazu ist der als Körper dienende Draht 21 von einer Heizwicklung 23 umgeben, die von einem Transformator 24 gespeist wird, wobei der Heizstrom durch einen Schalter 25 abschaltbar ist. Der Heizstrom kann aber auch aus der niedervoltigen Versorgungsspannung der Zähleinrichtung entnommen werden.

Die beschriebene Zweifachzähleinrichtung arbeitet folgendermassen:

Fliesst kein Heizstrom, liegt also die Temperatur des als Körper mit thermischem Gedächtniseffekt dienenden Drahtes 21 unter der unteren Veränderungstemperatur Ta, so ist dieser ausgedehnt, die Blattfeder 20 ist wenig gespannt, die Antriebseinrichtung 8 wird durch die Feder 13 in ihrer obersten Stellung gehalten, das Antriebszahnrad 11 ist im Eingriff mit dem oberen Rollenzählwerk 1 und dieses wird angetrieben. Gleichzeitig hemmt aber der untere Eingriff 15 des Hebels 12, der in seiner höchsten Stellung steht, das untere Rollenzählwerk 2 für die Aufnahme der Zählung. Wenn die Temperatur des Drahtes 21 unter der unteren Veränderungstemperatur Ta liegt, wird die Zählung also nur auf das obere Rollenzählwerk 1 übertragen.

Wird der Schalter 25 geschlossen, so heizt die Heizwicklung 23 den Draht 21 auf, dieser zieht sich zusammen, sobald er über die Temperatur Ts geheizt wird und erhält seine endgültige kleinere Gestalt nach Ueberschreiten der oberen Veränderungstemperatur Ta′. Die Blattfeder 20 wird nach unten gezogen und drückt die Antriebseinrichtung 8 entgegen der Wirkung der Feder 13 nach unten. Das Antriebszahnrad 11 senkt sich, sein Eingriff mit dem Rollenzählwerk 1 wird beendet, dafür greift es am Ende seiner Bewegung in das Rollenzählwerk 2 ein und treibt nun dieses an. Der obere Eingriff 14 des Hebels 12 senkt sich gleichzeitig ab und hemmt nun das obere Rollenzählwerk 1 für die Aufnahme der Zählung, während der untere Eingriff 15 in seine tiefste Stellung gelangt und damit die Hemmung des unteren Rollenzählwerks 2 aufhebt. Die Zählung wird also nur auf das untere Rollenzählwerk 2 übertragen, wenn die Temperatur des Drahtes 21 über der oberen Veränderungstemperatur Ta′ liegt.

Wird der Schalter 25 wieder geöffnet, so kühlt sich der Draht 21 ab, beginnt sich beim Erreichen der Temperatur Ts′ auszudehnen und erhält bei Temperaturen unter der Veränderungstemperatur Ta wieder seine ursprüngliche, ausgedehnte Länge. Es stellt sich damit wieder die im vorletzten Abschnitt geschilderte Situation her.

Der Energieverbrauch der beschriebenen Zweifachzähleinrichtung ist sehr gering, da zu ihrem Betrieb ja nur zeitweise der Draht 21 über die obere Veränderungstemperatur Ta′ erhitzt werden muss, was bei der kleinen Masse dieses Drahtes 21 und der daraus folgenden geringen Wärmekapazität keine grosse Leistung fordert.

Die Aenderung der Ausdehnung des Körpers mit thermischem Gedächtniseffekt lässt sich durch geeignete Wahl seiner Masse und der Leistung der Heizung 23 so langsam einstellen, dass der Wechsel in der Uebertragung der Zählung zwischen den Rollenzählwerken 1, 2 weich, aber dennoch beispielsweise innerhalb von 0,3 s erfolgt.

Die Fig. 5 zeigt als weiteres Beispiel eine Variante der beschriebenen Umschalteinrichtung 18. Hier wird der Draht 21 ohmsch erhitzt durch direktes Zuführen des Heizstromes vom Transformator 24. Es treten somit keine Verluste durch die Wärmeübertragung von der Heizwendel auf den Draht 21 auf. Es ist ferner keine Blattfeder 20 vorhanden, der Draht 21 ist direkt an den Hebel 12 geklemmt, wobei freiliich bei gleicher Drahtlänge der Hub des Hebels 12 verkleinert wird. In diesem Falle kann man den Hebel 12 sowohl als beweglichen Teil wie auch als Teil der Antriebseinrichtung 8 ansehen. Diese Umschalteinrichtung arbeitet sonst wie die in Fig. 3 und 4 dargestellte.

Die beschriebene Zweifachzähleinrichtung schaltet somit weich zwischen zwei Rollenzählwerken um, hat einen niederen Energieverbrauch und benötigt nur sehr preiswerte Bauteile zum Aufbau.

## Patentansprüche

1. Zweifachzähleinrichtung mit zwei Rollenzählwerken (1; 2) zur Zählung einer Größe, wie des Verbrauchs von Elektrizität, Wasser, mit einer Antriebseinrichtung (8) und einer Umschalteinrichtung (18), die wahlweise das Anschalten der Antriebseinrichtung (8) an eines der beiden Rollenzählwerke (1; 2) bewirkt und durch eine abschaltbare Heizung (23) steuerbar ist, welche zum mindestens zeitweisen Heizen eines Körpers (21) dient, dessen Länge (1) sich in Abhängigkeit von der Temperatur ändert,
**dadurch gekennzeichnet,**
daß für den Körper (21) ein Material mit einem thermischen Gedächtniseffekt solcher Art verwendet ist, daß sich dieser Körper (21) bei zunehmender Temperatur innerhalb eines Bereichs oberhalb einer unteren Veränderungstemperatur (Ta) und unterhalb einer oberen Veränderungstemperatur (Ta') stark zusammenzieht, daß die Umschalteinrichtung (18) die Antriebseinrichtung (8) bei einer Temperatur des Körpers (21) unterhalb der unteren Veränderungstemperatur (Ta) auf das eine Rollenzählwerk (1) und bei einer Temperatur des Körpers (21) oberhalb der oberen Veränderungstemperatur (Ta') auf das andere Rollenzählwerk (2) schaltet, und daß die Änderung der Länge (1) des Körpers (21) durch geeignete Wahl seiner Masse und der Leistung der Heizung (23) so langsam erfolgt, daß die Umschaltung der Übertragung der Zählung zwischen dem einen und dem anderen Rollenzählwerk (1, 2) die Größenordnung von einigen Zehntelsekunden in Anspruch nimmt.

2. Zweifachzähleinrichtung nach Anspruch 1,
**dadurch gekennzeichnet,**
daß die Heizleistung der Heizung (23) derart auf die Masse des Körpers (21) abgestimmt ist, daß die Umschaltung bis zu 0,3 s dauert.

3. Einrichtung nach Anspruch 1, dadurch gekennzeichnet, dass der Körper mit dem thermischen Gedächtniseffekt ein Draht (21) ist.

4. Einrichtung nach Anspruch 3, dadurch gekennzeichnet, dass der Draht (21) durch einen durchfliessenden Heizstrom direkt ohmsch heizbar ist.

5. Einrichtung nach Anspruch 1, dadurch gekennzeichnet, dass der Körper (21) in der Umschalteinrichtung (18) zwischen einem festen Teil (19) und einem beweglichen Teil (20 in Fig. 3 und 4, 12 in Fig. 5) mit zwei Klemmen (22, 22') befestigt ist, wobei der Körper (21) durch ein federndes Element (20 in Fig. 3 und 4, 13 in Fig. 5) gespannt ist.

6. Einrichtung nach Anspruch 1, dadurch gekennzeichnet, dass durch die Ausdehnungsänderung des Körpers (21) beim Uebergang von der einen zur anderen Veränderungstemperatur (Ta, Ta'), unmittelbar oder über zwischengeschaltete Glieder (20), eine Lageänderung der Antriebseinrichtung (8) hervorrufbar ist, durch welche die Uebertragung der Zählung auf das andere Rollenzählwerk (1, 2) bewirkt wird.

7. Einrichtung nach Anspruch 6, dadurch gekennzeichnet, dass durch die Ausdehnungsänderung des Körpers (21) beim Uebergang von der einen zur anderen Veränderungstemperatur (Ta, Ta'), unmittelbar oder über zwischengeschaltete Glieder (20), die Antriebseinrichtung (8) um einen kleinen Winkel um den Mittelpunkt des Zahnrades (9) schwenkbar ist, so dass dadurch das Antriebszahnrad (11) in das andere Rollenzählwerk (1, 2) eingreift.

8. Einrichtung nach einem der vorhergehenden Ansprüche, dadurch gekennzeichnet, dass durch die Ausdehnungsänderung des Körpers (21) beim Uebergang von der einen zur ande-

ren Veränderungstemperatur (Ta, Ta′), unmittelbar oder über zwischengeschaltete Glieder (12, 20), eine Lageänderung des oberen und des unteren Eingriffs (14, 15) hervorrufbar ist, so dass jeweils dasjenige Rollenzählwerk (1, 2) für die Aufnahme der Zählung gehemmt wird, das nicht im Eingriff mit dem Antriebszahnrad (11) steht.

9. Einrichtung nach einem der vorhergehenden Ansprüche, dadurch gekennzeichnet, dass der den thermischen Gedächtniseffekt aufweisende Körper (21) aus einer Legierung besteht, enthaltend 53,5 bis 56,5 % Nickel, der übrige Anteil ist Titan.

## Claims

1. A two-rate metering device with two roller metering mechanisms (1; 2) for metering a quantity such as the consumption of electricity, water, having a drive means (8) and a change-over means (18) which selectively causes the drive means (8) to be connected to one of the two roller metering mechanisms (1; 2) and is controllable by a heating means (23) which can be switched off and which serves for heating at least in a time-wise manner a body (21) whose length (1) changes in dependence on temperature, characterised in that the material used for the body (21) is a material having a thermal memory effect of such a nature that the body (21) contracts greatly with increasing temperature within a range above a lower variation temperature (Ta) and below an upper variation temperature (Ta'), that the change-over means (18) switches the drive means (8) to the one roller metering mechanism (1) when the body (21) is at a temperature below the lower variation temperature (Ta) and switches it to the other roller metering mechanism (2) when the body (21) is at a temperature above the upper variation temperature (Ta'), and that the change in the length (1) of the body (21), by virtue of suitable selection of its mass and the power of the heating means (23), occurs so slowly that switching over of the transmission of metering between one roller metering mechanism and the other (1, 2) requires the order of magnitude of several tenths of a second.

2. A two-rate metering device according to claim 1 characterised in that the heating output of the heating means (23) is so matched to the mass of the body (21) that the switching-over step lasts up to 0.3 s.

3. A device according to claim 1 characterised in that the body with the thermal memory effect is a wire (21).

4. A device according to claim 3 characterised in that the wire (21) can be directly ohmically heated by a heating current flowing therethrough.

5. A device according to claim 1 characterised in that the body (21) is fixed in the change-over means (18) between a fixed portion (19) and a movable portion (20 in Figure 3 and 4, 12 in Figure 5) by two clamps (22, 22'), the body (21) being stressed by a resilient element (20 in Figure 3 and 4, 13 in Figure 5).

6. A device according to claim 1 characterised in that a change in position of the drive means (8), by which metering is transferred to the other roller metering mechanism (1, 2), can be caused, directly or by way of interposed members (20), by the change in extension of the body (21) at the transition from the one variation temperature to the other (Ta, Ta').

7. A device according to claim 6 characterised in that the drive means (8) is pivotable through a small angle about the centre point of the gear (9), directly or by way of interposed members (20), by the change in extension of the body (21) at the transition from the one variation temperature to the other (Ta, Ta'), so that in that way the drive gear (11) engages into the other roller metering mechanism (1, 2).

8. A device according to one of the preceding claims characterised in that a variation in position of the upper and lower engagement (14, 15) can be caused, directly or by way of interposed members (12, 20), by the change in extension of the body (21) at the transition from the one variation temperature to the other (Ta, Ta'), so that that respective roller metering mechanism (1, 2) which is not in engagement with the drive gear (11) is inhibited in regard to receiving the metering action.

9. A device according to one of the preceding claims characterised in that the body (21) which has the thermal memory effect comprises an alloy containing from 53.5 to 56.5% nickel, the remaining component is titanium.

## Revendications

1. Dispositif pour double comptage, comportant deux compteurs à rouleaux (1 ; 2) pour le comptage d'une donnée, comme la consommation d'électricité, d'eau, comportant un dispositif d'entraînement (8) et un dispositif de commutation (18), qui produit sélectivement l'accouplement du dispositif d'entraînement (8) avec un des deux compteurs a rouleaux ( 1 ; 2) et qui peut être commandé par un élément chauffant (23) pouvant être désexcité et qui sert à chauffer, au moins temporairement, un corps 21 dont la longueur (1) varie en fonction de la température, caractérisé en ce qu'on utilise pour le corps (21) un matériau ayant un effet de mémoire thermique d'une particularité telle que ce corps (21), lors d'une augmentation de la température dans une plage supérieure à une température inférieure de modification (Ta) et inférieure à une température supérieure de modification (Ta'), se contracte fortement, en ce que le dispositif de commutation (18) produit, pour une température du corps (21) qui est inférieure à la température supérieure de modification (Ta), un accouplement du dispositif d'entraînement (8) avec un des compteurs à rouleaux (1) et, pour une température du corps (21) qui est supérieure à la température supérieure de modification (Ta'), un accouplement du dispositif de commutation (18) avec l'autre compteur à rouleaux (2), et en ce que la modification de longueur (1) du corps (21) est produite, par un choix approprié de sa masse et de la puissance de l'élément chauffant (23), suffisamment lentement pour que la commutation du mode de comptage entre l'un et l'autre compteur à rouleaux (1, 2), s'effectue dans un intervalle de temps d'un ordre de grandeur de quelques dixièmes de seconde.

2.  Dispositif pour double comptage selon la revendication 1, caractérisé en ce que la puissance de chauffe de l'élément chauffant (23) est déterminée en fonction de la masse du corps (21) de telle sorte que la commutation dure jusqu'à 0,3 seconde.

3.  Dispositif selon la revendication 1, caractérisé en ce que le corps avec effet de mémoire thermique est un fil (21).

4.  Dispositif selon la revendication 3, caractérisé en ce que le fil (21) peut être chauffé directement par résistance au moyen d'un courant de chauffage passant dans ce fil.

5.  Dispositif selon la revendication 1, caractérisé en ce que le corps (21) est fixé dans le dispositif de commutation (18) entre une partie fixe (19) et une partie mobile (20 sur la Figure 3 et 4, 12 sur la Figure 5 ) au moyen de deux pinces (22, 22'), le corps (21) étant tendu par un élément élastique (20 sur la Figure 3 et 4, 13 sur la Figure 5 ).

6.  Dispositif selon la revendication 1, caractérisé en ce que, sous l'effet d'une variation de dimension du corps (21) lors d'une transition de l'une à l'autre température de modification (Ta, Ta'), une variation de position du dispositif d'entraînement (8) peut être produite, directement ou au moyen d'organes intermédiaires (20), de façon à transférer la fonction de comptage à l'autre compteur à rouleaux (1, 2).

7.  Dispositif selon la revendication 6, caractérisé en ce que, sous l'effet de la variation de dimension du corps (21) lors d'une transition de l'une à l'autre température de modification (Ta, Ta'), le dispositif d'entraînement (8) peut pivoter, directement ou au moyen d'organes intermédiaires (20), d'un petit angle autour du centre de la roue dentée (9) de telle sorte que la roue dentée d'entraînement (11) entre en prise avec l'autre compteur à rouleaux (1, 2).

8.  Dispositif selon une des revendications précédentes, caractérisé en ce que, sous l'effet de la variation de dimension du corps (21) lors d'une transition de l'une a l'autre température de modification (Ta, Ta'), une variation de position de l'élément supérieur d'accouplement (14) ou de l'élément inférieur d'accouplement (15) puisse être produite, directement ou au moyen d'organes intermédiaires (12, 20), de telle sorte qu'à chaque fois le compteur à rouleaux (1, 2) qui n'est pas en prise avec la roue dentée d'entraînement (11) soit bloqué pour l'enregistrement du comptage.

9.  Dispositif selon une des revendications précédentes, caractérisé en ce que le corps (21) présentant l'effet de mémoire thermique se compose d'un alliage contenant de 53,5 à 56,5 % de nickel et le complément de titane.

# Fig.1

# Fig.2

# Fig.5

## Fig. 3

## Fig. 4